# EUROPEAN PATENT APPLICATION

(11) **EP 4 712 757 A1**
(43) Date of publication of application: **18.03.2026**
(21) Application number: 25199104.8
(22) Date of filing: 29.08.2025
(51) Int. Cl.: H10W 70/40, H10W 70/04, H10W 74/10, B81B 7/00

(54) **MOLDED PACKAGES WITH ATTACHED CONNECTORS**

(30) Priority: 12.09.2024 US 202418883346
(71) Applicant: NXP USA, Inc., Austin, TX 78735 (US)
(72) Inventor: Hooper, Stephen Ryan, 5656 AG Eindhoven (NL); Saklang, Chayathorn, 5656 AG Eindhoven (NL); Sessego, Raimondo, 5656 AG Eindhoven (NL); Suwankasab, Chanon, 5656AG Eindhoven (NL); Kanth, Namrata, 5656AG Eindhoven (NL)
(74) Representative: Schmütz, Christian Klaus Johannes

(57) **Abstract**

An electronic device has a molded package (e.g., a quad flat no leads package) with attached connectors. The molded package includes one or more semiconductor dies and is pretested prior to attachment of the connectors. Along these lines, such molded packages may be pretested in parallel at high volume due to their relatively small form factor (e.g., at numbers several times greater than those for testing leaded socket assemblies). Following such pretesting, the connectors are attached to the pretested molded package (e.g., by directly fusing the connectors to metallic pads on surfaces of the packaged integrated circuit via laser welding or soldering). Such electronic devices may be further tested if desired (e.g., opens/shorts tested) and encased within housings to form larger modules (e.g., accelerometers, pressure sensors, etc.).

## Description

### TECHNICAL FIELD

This disclosure relates generally to electronic devices, and more particularly to products that involve molded packages.

### BACKGROUND

Electronic components including sensors are frequently packaged into molded packages which can protect the components from damage and provide electrical contacts allowing the components to be electrically connected to other devices. Some components are packaged into small form factor packages that are designed to be mounted with other components on circuit boards or other assemblies. In some applications, larger packages with leads that protrude beyond the package surfaces are designed to be inserted into sockets or other fixtures, thereby allowing the components to be easily removed for testing or replacement.

A conventional process for creating a packaged component of this kind includes encapsulating a sensor die and passive devices, which are attached to a lead frame, to form a molded body having blade-type leads that extend from one or more edges of the molded body. The resulting part may be referred to as a leaded socket assembly or unit. The conventional process then includes encasing the leaded socket assembly within a housing to form a sensor module.

### BRIEF DESCRIPTION OF THE DRAWINGS

The foregoing and other objects, features and advantages will be apparent from the following description of particular embodiments of the present disclosure, as illustrated in the accompanying drawings in which like reference characters refer to the same parts throughout the different views. The drawings are not necessarily to scale, emphasis instead being placed upon illustrating the principles of various embodiments of the present disclosure.
FIG. 1 is a transparent isometric view of an example molded package in accordance with one or more embodiments.
FIG. 2 is cross sectional side view of the example molded package in accordance with one or more embodiments.
FIG. 3 is a different isometric view of the example molded package in accordance with one or more embodiments.
FIG. 4 is a bottom view of the example molded package in accordance with one or more embodiments.
FIG. 5 is a perspective view of componentry for an electronic device in accordance with certain embodiments.
FIG. 6 is a perspective view of an assembled electronic device in accordance with one or more embodiments.
FIG. 7 is a different perspective view of the assembled electronic device in accordance with one or more embodiments.
FIG. 8 is a side view of the assembled electronic device in accordance with one or more embodiments.
FIG. 9 is a flowchart of a procedure for providing an electronic device in accordance with one or more embodiments.
FIG. 10 is a transparent perspective view of a sensor module in accordance with one or more embodiments.

### DETAILED DESCRIPTION

Some packaged components are provided in small, dense packages. However, certain applications may exist in which it is better to use larger "discrete" components with macroscopic leads. Smaller packages can be desirable in part because they can be fabricated in panel level processes in which numerous lead frame units are fabricated in parallel; the smaller the package size, the more units can be fabricated using a fixed panel size and, also the more units which can be tested simultaneously. However, conventional processes for producing packaged components with large protruding leads require using lead frames which include the large leads, thus limiting the number of packages that can be assembled from a single lead frame panel and limiting the number of components that can be tested at one time in conventional test fixtures. What is needed, therefore, is a way to effectively accommodate both situations.

The above need is addressed at least in part by applying low-cost (high density) packaging techniques to produce compact sensors economically, while enabling these compact packages to be adapted to use cases that involve "discrete" style components with large scale leads. Such adapted components are well suited for easy insertion into, and removal from, sockets (e.g., to allow for replacement of a faulty sensor in a vehicle).

**In** accordance with one or more embodiments, electronic devices are provided as molded packages with connectors attached after packaging. Such molded packages may include semiconductor dies with the same or similar functionality as those within leaded socket assemblies.

Additionally, the molded packages may be pretested prior to attachment of the connectors. Along these lines, multiple molded packages may be evaluated in parallel at high volume due to their relatively small form factor (e.g., at numbers several times greater than that when testing leaded socket assemblies). Following such pretesting, the connectors are attached to the pretested molded packages to form the electronic devices (e.g., by directly fusing the connectors to metallic pads on surfaces of the molded packages via laser welding or soldering). Accordingly, a large number of units may be pretested in parallel without consuming additional resources. Furthermore, the resulting electronic devices are comparable to leaded socket assemblies, e.g., by utilizing the same or similar semiconductor dies or die stacks, by having a similar form factor suitable for encasing within housings to form sensor modules, and so on.

The various individual features of the particular arrangements, configurations, and embodiments disclosed herein can be combined in any desired manner that makes technological sense. Additionally, such features are hereby combined in this manner to form all possible combinations, variants and permutations except to the extent that such combinations, variants and/or permutations have been expressly excluded or are impractical. Support for such combinations, variants and permutations is considered to exist in this document.

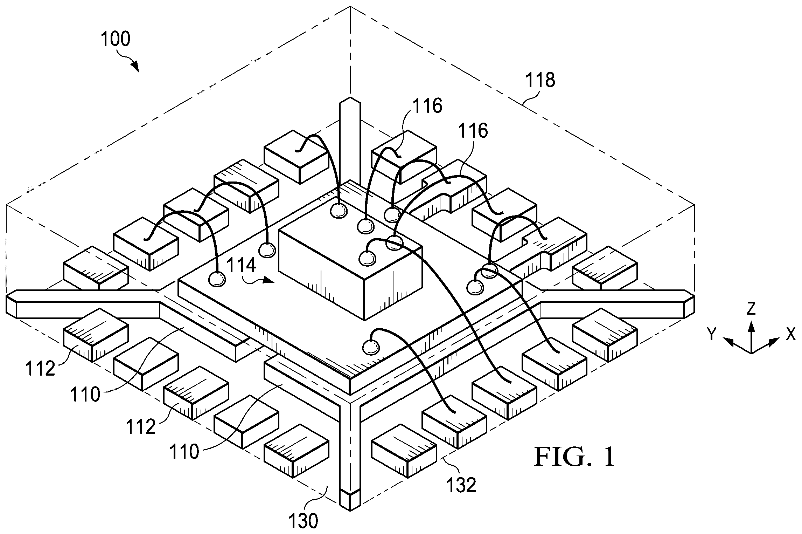

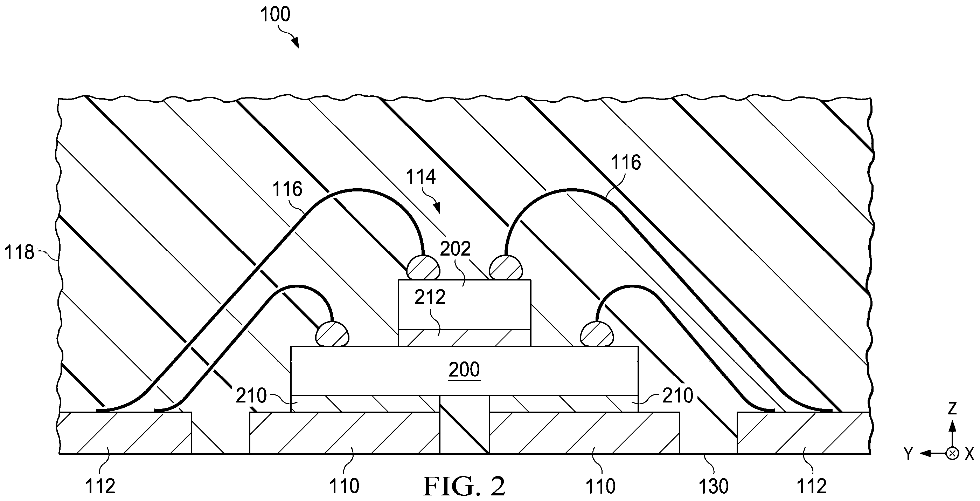

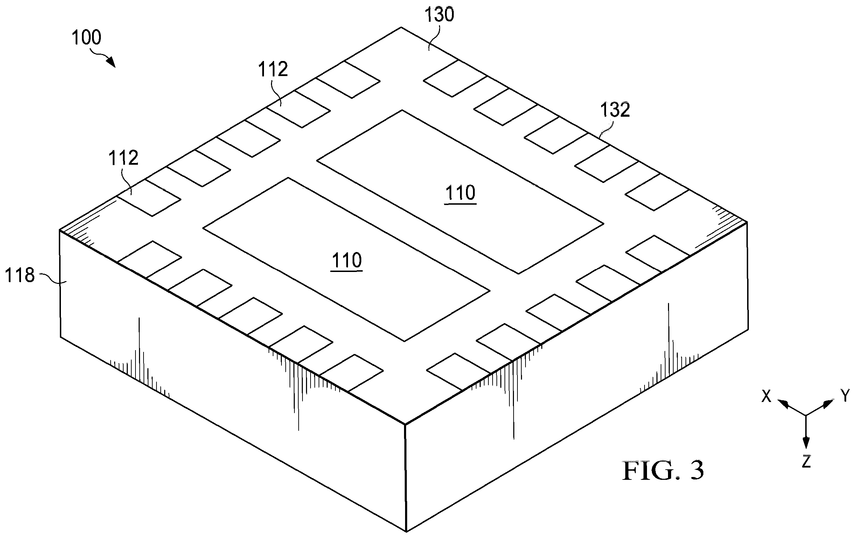

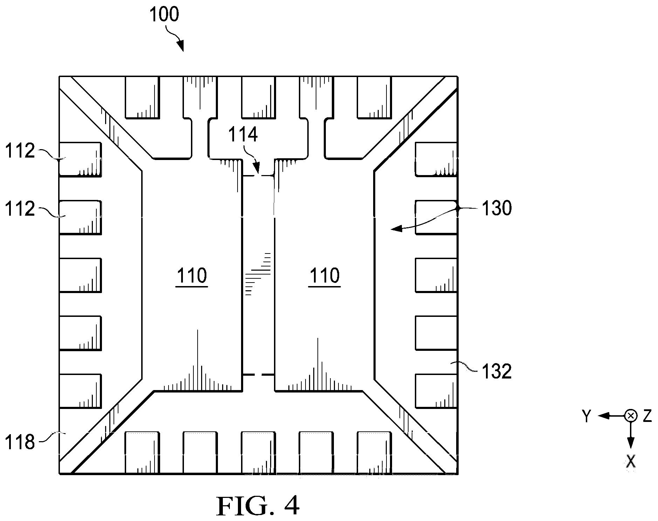

FIGS. 1 through 4 show an example molded package 100 in accordance with one or more embodiments. FIG. 1 is a transparent isometric view of the example molded package 100. FIG. 2 is cross sectional side view of the example molded package 100. FIG. 3 is an isometric view of the example molded package 100 from a different angle. FIG. 4 is a bottom view of the example molded package 100.

The example molded package 100 includes a set of metallic pads (also called flags) 110, a set of perimeter terminals (also called lands) 112, a set of semiconductor dies 114, bond wires 116, and encapsulation material 118. It should be understood that the encapsulation material 118 defines a bottom surface 130 which is generally rectangular (or quad-shaped) and appears square by way of example only.

The set of metallic pads 110 may include one or more pads and is disposed on the bottom surface 130 within a plane (e.g., an X-Y plane) and is constructed and arranged to provide external electrical access to the set of semiconductor dies 114. Along these lines and as will be explained in further detail shortly, the set of metallic pads 110 is exposed and provides a set of surfaces which is well suited for connector attachment. The set of metallic pads 110 is further constructed and arranged to serve as a base on which to attach the set of semiconductor dies 114.

By way of example only, the set of metallic pads 110 includes two rectangular metallic pads 110, which may be referred to as a "split flag" arrangement, disposed within a central region of the bottom surface 130 of the molded package 100. In other arrangements, there is a different number of metallic pads 110 exposed on the bottom surface 130 (e.g., one, three, four, etc.).

The set of perimeter terminals 112 is disposed around outer edges 132 of the bottom surface 130 and is constructed and arranged to provide external electrical access to the set of semiconductor dies 114, e.g., for testing purposes. Along these lines and as will be explained in further detail shortly, certain perimeter terminals 112 may electrically connect with the set of semiconductor dies 114 via bond wires 116 and thus may be probed/tested by test equipment to confirm proper operation. In some arrangements, the set of metallic pads 110 electrically connect with the set of semiconductor dies 114 through various perimeter terminals 112 and bond wires 116.

It should be understood that the perimeter terminals 112 are arranged around the edges 132 of the bottom surface 130 of the molded package 100 in groups (or series) of five terminals 112 by way of example only. However, there is no requirement that the groups have the same number of perimeter terminals 112, and any of the groups may have a different number of perimeter terminals 112.

The set of semiconductor dies 114 is constructed and arranged to perform various operations with certain functionality. In one or more embodiments, there is a single semiconductor die (e.g., a bare semiconductor die or a die mounted on a ceramic carrier or other suitable carrier substrate). In one or more embodiments, there are multiple semiconductor dies.

In one or more embodiments, the set of semiconductor dies 114 is a die stack which includes a lower die 200 and an upper die 202 (e.g., see FIG. 2). For example, the lower die 200 may be an application specific integrated circuit (ASIC) and the upper die 202 may be a micro-electromechanical system (MEMS) device. In these embodiments, a bottom side of the lower die 200 may attach to the set of metallic pads 110 via die attach material 210 (e.g., using epoxy, other adhesive, etc. or metallurgical die attachment using soldering or sintering, etc.), and a bottom side of the upper die 202 may attach to a top side of the lower die 200 via similar die attach material 212.

In one or more embodiments, there is a substrate or carrier on which the set of semiconductor dies 114 reside. For example, a carrier substrate may be put in place of the lower die 200 or under the lower die 200.

In some arrangements, passive component functionality (e.g., resistors, capacitors, etc. to manage voltages and currents) is built in to the set of semiconductor dies 114. Such arrangements alleviate the need for the molded package 100 to include discrete passive components.

The bond wires 116 are constructed and arranged to electrically connect the set of perimeter terminals 112 to the set of semiconductor dies 114. Along these lines, the set of semiconductor dies 114 is provisioned with top-side electrode pads that allow for providing power, ground, and signals to the integrated circuitry therein, and for receiving signals therefrom. Accordingly, the bond wires 116 may be installed between the electrode pads and the perimeter terminals 112 using known wire bonding processes and commercially available wire bonding machines. Furthermore, the bond wires 116 may comprise commercially available copper or gold wires, may be coated with palladium to prevent oxidation and allows for good bonds, and so on.

The encapsulation material 118 (e.g., a plastic molded body) is constructed and arranged to protect the various covered elements from potential environmental influences such as moisture and dust. Additionally, the encapsulation material 118 can provide structural strength and protect against mechanical damage.

It should be understood that the above-described details of the molded package 100 were provided by way of example only, and that the molded package 100 may include other componentry and/or be provisioned with other features. For example, the molded package 100 may include other elements such as other lead frame style traces/metallic structures for electrical conductivity, strength, manufacturability, and so on.

Such a molded package 100 may be produced via a process which involves mounting the set of semiconductor dies 114 onto a lead frame (e.g., the dashed lines in FIG. 4 show the set of semiconductor dies 114 sitting on top of the set of metallic pads 110). Such a lead frame (e.g., a metal manifold onto which components can be bonded in order to couple interconnects on the component to one or more structures which will become the terminals of a finished package) includes a lead pattern that eventually becomes the set of metallic pads 110 and the set of perimeter terminals 112. The process further involves electrically connecting the set of semiconductor dies 114 to the set of perimeter terminals 112 via wire bonding, subsequent overmolding, and singulation.

It should be appreciated that such wire bonding electrically connects the set of metallic pads 110 and the set of perimeter terminals 112 to the set of semiconductor dies 114. Along these lines and as referred to earlier, various perimeter terminals 112 electrically connect with electrode pads of the set of semiconductor dies 114 via bond wires 116. Additionally, the set of metallic pads 110 connect with the set of perimeter terminals 112 through lead-style structures (e.g., the same lead frame material that forms the metallic pads 110 and the perimeter terminals 112) and/or bond wires 116. Accordingly, both the set of metallic pads 110 and the set of perimeter terminals 112 provide electrical access to the set of semiconductor dies 114.

According to one or more embodiments, the molded packages 100 are quad flat no-leads (QFN) packages, which are traditionally configured for surface-mount attachment to circuit boards using soldering. However, in place of the single centrally located thermal pads which would typically be soldered to circuit boards via a surface-mount technology (SMT) process, the metallic pads 110 of the molded packages 100 are directly fused to metallic connectors to enable connection to structures/componentry other than circuit boards, such as sockets for replaceable components in a vehicle, other standard connectors, and the like to exchange input/output (I/O) signals.

At this point, it should be understood that prior to connector attachment, the molded package 100 may be pretested in parallel with other molded packages 100 to produce pretested molded packages. Along these lines, such pretesting may involve a process that uses pick & place equipment to position a large number of the molded packages 100 onto a text fixture (or other testing equipment) that electrically connects with various perimeter terminals 112 of the molded packages 100. For example, the molded packages 100 can be tested using existing high-rate equipment designed for small packages like QFN prior to final assembly with external leads.

The process then applies electrical signals to and/or samples electrical signals from the set of perimeter terminals 112 to determine whether the molded packages 100 operate properly. In some embodiments, the molded packages 100 include sensors (e.g., MEMS devices). Along these lines, the process may involve electrically monitoring the molded packages 100 while putting the molded packages 100 through one or more stimuli, stresses, etc. (e.g., acceleration, deceleration, pressure, vibration, temperature change, angular displacement, combinations thereof, and so on). Failing molded packages 100 may be discarded, salvaged, reworked, etc. while passing molded packages 100 may be put to use and/or combined with other componentry to form larger apparatus.

It should be appreciated that the relatively small footprint of a molded package 100 enables many more molded packages 100 to be loaded onto available test equipment than leaded socket assemblies with blade-type leads. Accordingly, testing throughput for molded packages 100 is higher and can alleviate the need to increase testing capacity, e.g., by adding more testing resources.

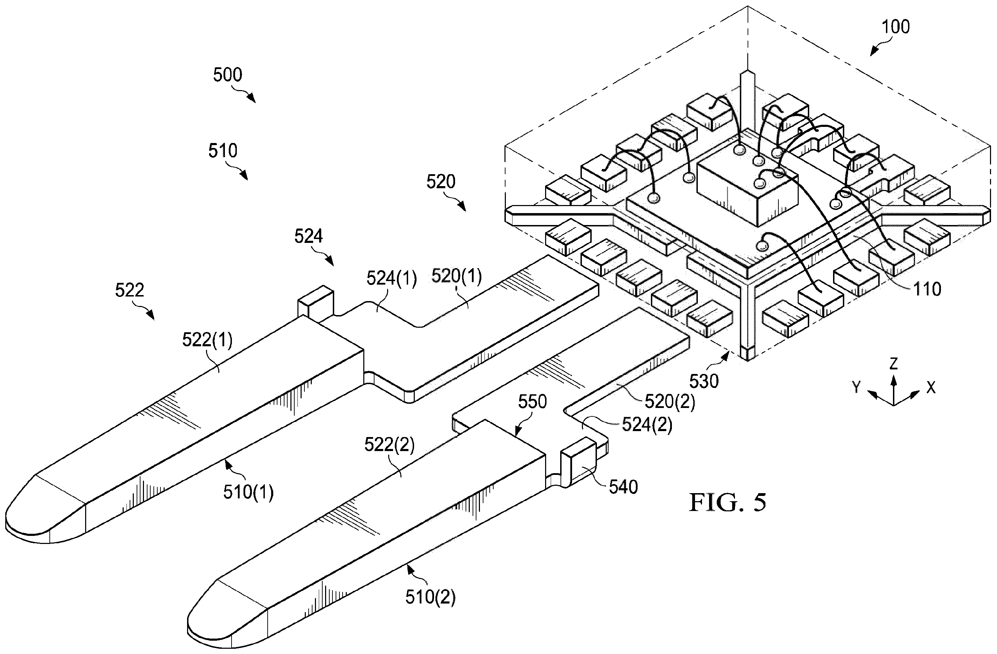

In some arrangements, the length of the molded package 100 along the X-direction is within the range of 4.0mm to 6.0mm. Additionally, the width of the molded package 100 along the Y-direction is within the range of 4.0mm to 6.0mm. Furthermore, the perimeter terminals 112 may be less than 1.00mm wide as measured along the edges 132. Other dimensions are suitable for use as well, and the indicated dimensions are provided merely for illustration. Further details will now be provided with reference to FIGS. 5 through 8.

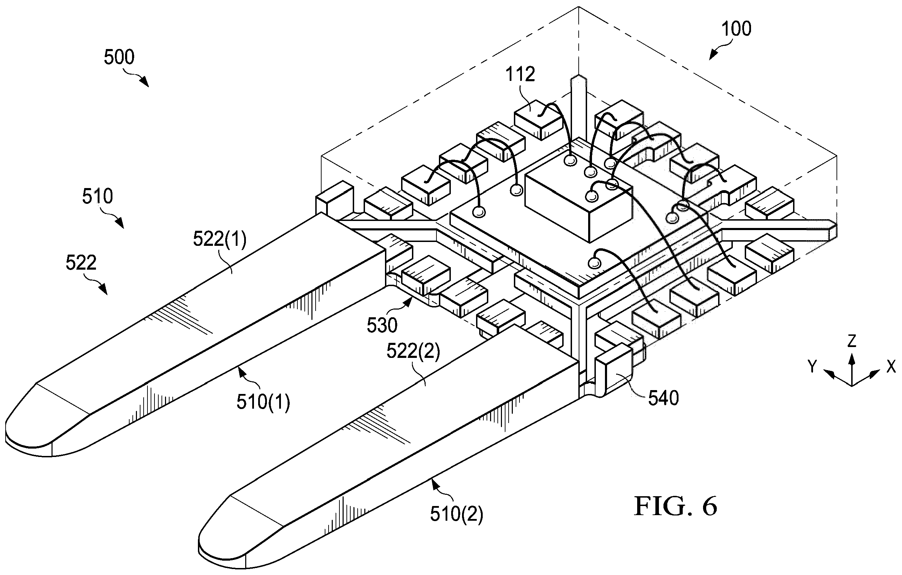

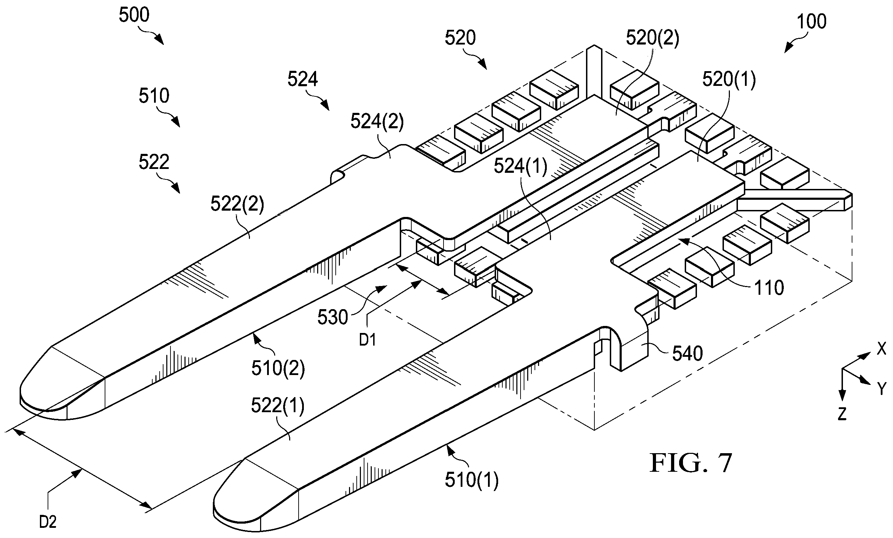

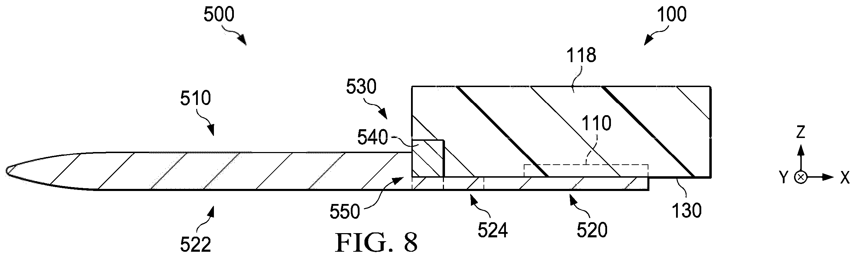

FIGS. 5 through 8 show an electronic device 500 in accordance with certain embodiments. FIG. 5 is a perspective view of certain componentry which forms the electronic device 500. FIG. 6 is a perspective view of the electronic device 500 in an assembled state. FIG. 7 is a different perspective view of the electronic device 500 in the assembled state. FIG. 8 is a side view of the electronic device 500 in the assembled state.

Once a molded package 100 (e.g., a packaged integrated circuit, an electromechanical component, etc.) has successfully completed pretesting, the molded package 100 is ready for assembly as shown in FIG. 5. Along these lines, automated equipment attaches a set of connectors 510 to the set of metallic pads 110 of the molded package 100 (e.g., also see FIGS. 1 through 4).

In some embodiments, the automated equipment fuses the set of connectors 510 directly to the set of metallic pads 110 to form robust and reliable electrical and mechanical bonds. It should be appreciated that such bonding of the set of connectors 510 directly to the set of metallic pads 110 alleviates the need to use a printed circuit board (PCB) as an intermediate component. That is, there is no need to supply a PCB assembly having blade-type leads, and no need to mount the molded package 100 to such a PCB assembly.

As best seen in FIG. 5 and in accordance with one or more embodiments, the set of connectors 510 includes two connectors 510(1), 510(2) since the example molded package 100 has two rectangular metallic pads 110 (e.g., a split flag arrangement). In one or more other embodiments, such as those in which the molded package 100 has a different number of signals to be externally accessed, there may be a different number of connectors 510 (e.g., one, three, four, etc.).

As best seen in FIGS. 5 and 7, the connectors 510 include proximal metallic pad ends 520 and distal free ends 522. Along these lines, the connector 510(1) has a metallic pad end 520(1) which attaches to a first metallic pad 110 and a free end 522(1). Similarly, the connector 510(2) has a metallic pad end 520(2) which attaches to a second metallic pad 110 and a free end 522(2). In one or more embodiments, the metallic pad ends 520 of the connectors 510 mirror the geometries of the corresponding metallic pads 110.

In accordance with one or more embodiments and after assembly of the connectors 510 to the molded package 100, the connectors 510 directly contact and fuse with the metallic pads 110. Along these lines, high-strength bonds then exist between the connectors 510 and metallic pads 110, which provide rich and reliable resiliency and durability. Such bonds (or joints) may be formed via a variety of fusing techniques such as laser welding, soldering, and the like.

Once the connectors 510 are attached to the metallic pads 110, the connectors 510 provide electrical access to the set of semiconductor dies 114. Along these lines and as mentioned earlier, the set of metallic pads 110 may electrically connect with the set of perimeter terminals 112 through lead-style structures and/or bond wires 116, and the set of perimeter terminals 112 electrically connect with the set of semiconductor dies 114 via bond wires 116 (also see FIGS. 1 and 2).

According to one or more embodiments, the connectors 510 further include intermediate sections 524 which connect the metallic pad ends 520 with the free ends 522. Along these lines, the connector 510(1) has an intermediate section 524(1) which connects the metallic pad end 520(1) with the free end 522(1). Likewise, the connector 510(2) has an intermediate section 524(2) which connects the metallic pad end 520(2) with the free end 522(2).

It should be appreciated that the connectors 510 are not necessarily identical. Rather, the connectors 510 may extend in different directions (e.g., as viewed in FIG. 7, the connector 510(2) jogs outwardly to the left in the negative Y-direction while the connector 510(1) jogs outwardly to the right in the positive Y-direction).

Furthermore, as illustrated in FIG. 7, the pad ends 520 of the connectors 510 are separated by a first distance (D1), and the free ends 522 of the connectors 510 are separated by a second distance (D2) that is greater than the first distance (D1). Accordingly, the connectors 510 are able to attach to the metallic pads 110 of the molded package 100 and provide the electronic device 500 with a larger connecting interface suitable for connecting with larger structures (e.g., enabling easier connection of the connectors 510 with another component or device).

According to one or more embodiments, the connectors 510 are dual gauge in that the connectors 510 have two thicknesses (e.g., as measured along the Z-axis). Accordingly, the electronic device 500 is able to maintain a relatively low profile along the Z-direction, but provide the free ends 522 with strength, resiliency, durability, etc.

According to one or more embodiments, the metallic pad ends 520 and the intermediate sections 524 have a first thickness, and the free ends 522 have a second thickness which is greater than the first thickness. For example, the second thickness may be at least twice that of the first thickness. With the thinner metallic pad ends 520, less heat needs to be applied when fusing the connectors 510 to the metallic pad ends 520.

According to one or more embodiments, the intermediate sections 524 run along a connector side 530 (or edge) of the molded package 100 for enhanced support/stability. Along these lines and as will be explained in further detail shortly, the different heights of the free ends 522 and the intermediate sections 524 provides stops (or steps) which facilitate connector alignment.

According to one or more embodiments, the perimeter terminals 112 along a connector side 530 of the molded package 100 (e.g., see FIG. 6) are electrically isolated from the semiconductor die 114 through the molded package 100. Accordingly, such perimeter terminals 112 will not provide electrical access to the semiconductor die 114 through the molded package 100 in a situation in which there is electrical/physical contact between a connector 510 and one or more of these perimeter terminals 112.

According to one or more embodiments, one or more of the connectors 510 includes a tab 540 which extends upwardly in the positive Z-direction (perpendicularly from the X-Y plane defined by the bottom surface 130 of the molded package 100). Such a tab 540 facilitates alignment/orientation of the connector 510 with the molded package 100 along the Y-axis when the connector 510 is placed in position for attachment. In the two-connector arrangement shown in FIGS. 5 through 8 and by way of example only, all of the connectors 510 are provisioned with tabs 540.

As best seen in FIG. 8, portions of the connectors 510 (e.g., the free ends 522) extend in the negative X-direction beyond the bottom surface 130 defined by the molded portion 118 of the molded package 100. In some embodiments, for one or more connectors 510, the transition between the intermediate section 524 and the free end 522 forms a step 550 (e.g., see FIGS. 5 and 8). Such a step 550 facilitates alignment/orientation of the connector 510 with the molded package 100 along the X-axis when the connector 510 is placed in position for attachment.

According to one or more embodiments, one or more connectors 510 includes a tab 540 and a step 550 to facilitate proper alignment/orientation of the connector 510 with the metallic pads 110 prior to connector attachment. In such embodiments, the tab 540 and the step 550 of such a connector 510 form a corner which fits around a corresponding corner of the molded package 100.

As best seen in FIG. 8 and in accordance with certain embodiments, no part of the connectors 510 is overmolded since the connectors 510 attach to the molded package 100 after packaging and testing. Rather, the top sides of the metallic pad ends 520 of the connectors 510 contact the metallic pads 110 and are flush with the bottom surface 130 of the molded package 100. Additionally, and the entire bottom sides of the connectors 510 are exposed.

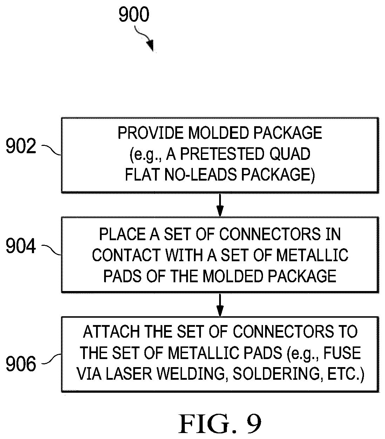

It should be understood that, after the connectors 510 are attached to the pack molded package 100, the electronic device 500 may be further tested if desired. Along these lines, automated equipment may perform open/short testing of the electronic devices 500 to confirm proper attachment of the connectors 510. Further details will now be provided with reference to FIG. 9.

FIG. 9 shows a flowchart of a procedure 900 for providing an electronic device in accordance with certain embodiments. Such a procedure 900 may be performed to avoid testing bottlenecks during production without necessitating additional testing resources.

At 902, a molded package (e.g., a packaged IC, an electromechanical component, etc.) is provided. Such a molded package includes a semiconductor die, a set of metallic pads that electrically couples with the semiconductor die, and a set of perimeter terminals disposed around the set of metallic pads. As explained earlier, such a molded package may be provided via a process which involves mounting the semiconductor die to a lead frame, wire bonding the semiconductor die to the set of perimeter terminals, overmolding, and singulation.

At this point, the molded package may be pretested. Along these lines, the small form factor of the molded package enables testing a large number of units in parallel on a test fixture. Such high volume testing on the test fixture is unavailable for larger size components such as leaded socket assemblies.

As mentioned earlier in connection with FIGS. 1 through 4, such testing may involve electrically accessing the semiconductor dies through the sets of perimeter terminals. In some embodiments, the molded package is physically and/or electrically stressed during such testing.

At 904, a set of connectors is placed in contact with the set of metallic pads of the molded package. Along these lines, the set of metallic pads may include a first metallic pad and a second metallic pad side by side on a bottom surface of the molded package, and automated equipment may position a first connector in contact with the first metallic pad and a second connector in contact with the second metallic pad.

At 906, the set of connectors is attached to the set of metallic pads to form the electronic device. Here, the first connector is fused to the first metallic pad and the second connector is fused to the second metallic pad (e.g., via laser welding, soldering, etc.).

It should be understood that additional testing may be performed on the electronic device after connector attachment (e.g., opens/shorts testing). At this point, the electronic device is ready for use.

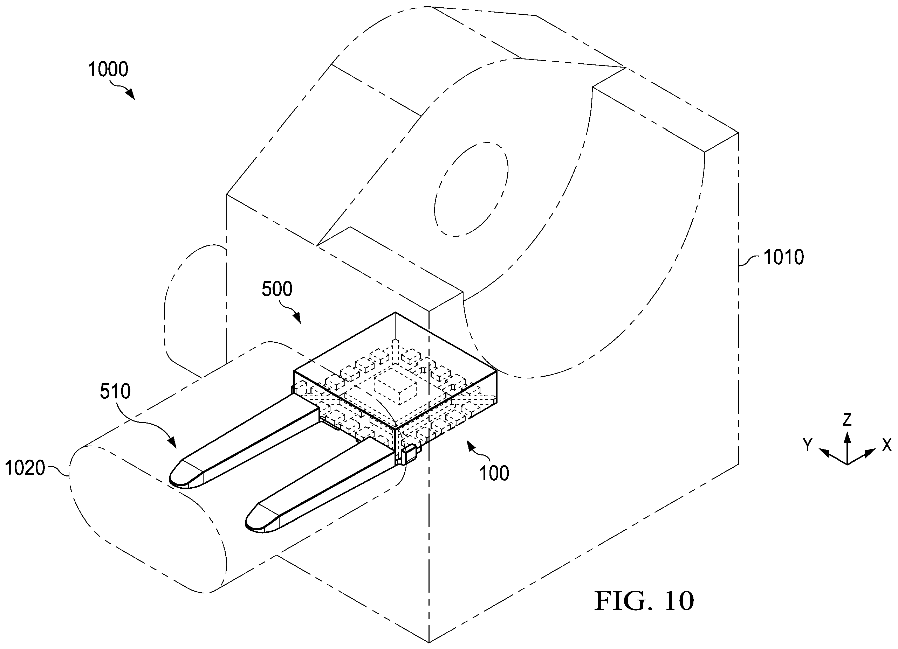

FIG. 10 shows a transparent perspective view of a sensor module 1000 in accordance with one or more embodiments. The sensor module 1000 includes an electronic device 500 (also see FIGS. 5 through 8) and a housing 1010. The electronic device 500 may have been provided via the procedure 900 (also see FIG. 9).

The housing 1010 (shown in phantom) is constructed and arranged to protect and shield the electronic device 500. **In** some embodiments, the electronic device 500 is encased within the housing 1010. For example, the housing 1010 may be formed around the electronic device 500 using a custom mold tool. Alternatively, the housing 1010 may comprise two or more mating pieces that define a cavity within for receiving the electronic device 500.

As shown in FIG. 10, the set of connectors 510 of the electronic device 500 is oriented so that they are accessible via an opening 1020 in the housing 1010. Additionally, the housing 1010 may provide and/or define other features based on the particular situation (e.g., one or more mounting holes, an interface to engage with another object, etc.). Such an arrangement allows the electronic device 500 to be fitted at desired locations such as in a desired location of an automobile, tailored to accommodate certain external components/devices, and so on.

It should be appreciated that the various features, form factors, geometries, etc. provided by the electronic device 500 and/or the sensor module 1000 make the electronic device 500 and/or the sensor module 1000 well suited for a variety of applications. Moreover, these aspects enable the electronic device 500 and/or the sensor module 1000 to easily accommodate and/or satisfy industry standards.

As described above, certain improved techniques are directed to providing electronic devices 500 as molded packages 100 with connectors 510 attached after packaging. Such packaged integrated circuits 100 may include semiconductor dies 114 with the same or similar functionality as those within leaded socket assemblies. However, the molded packages 100 may be pretested prior to attachment of the connectors 510. Along these lines, multiple packaged integrated circuits 100 may be evaluated in parallel at high volume due to their relatively small form factor (e.g., at numbers several times greater than that when testing leaded socket assemblies). Following such pretesting, the connectors 510 are attached to the pretested molded packages to form the electronic devices 500 (e.g., by directly fusing the connectors 510 to metallic pads 110 on surfaces 130 of the molded package 100 via laser welding or soldering). Accordingly, a large number of units may be pretested in parallel without consuming additional resources. Furthermore, the resulting electronic devices 500 are comparable to leaded socket assemblies, e.g., by utilizing the same or similar semiconductor dies or die stacks, by having a similar form factor suitable for encasing within housings 1010 to form sensor modules 1000, and so on.

While various embodiments of the present disclosure have been particularly shown and described, it will be understood by those skilled in the art that various changes in form and details may be made therein without departing from the scope of the present disclosure. Such modifications and enhancements are intended to belong to various embodiments of the disclosure.

It should be appreciated that instead of realizing connectors as part of the lead frame, packaged integrated circuits have connectors directly attached to their metallic pads (or flags) in accordance with certain embodiments. Along these lines, a QFN package may have multiple flags which attach directly to connectors (e.g., via laser welding or soldering). In some embodiments, there is a split flag configuration in which there are two centrally located flags side by side for I/O instead of a traditional thermal pad.

In such embodiments, the semiconductor dies are able to incorporate the same or similar functionality as that of leaded socket assemblies. However, in such embodiments, the form factor for the molded packages may be substantially smaller thus enabling a greater number of units to be tested in parallel thus improving efficiency and reducing costs. Along these lines, the number of units that are put through a final test together using a test fixture may be several times greater than that for leaded socket assemblies.

Certain embodiments are directed to an electronic device including a molded package which has a semiconductor die, a set of metallic pads that electrically couples with the semiconductor die, and perimeter terminals disposed around the set of metallic pads. The electronic device further includes a set of connectors attached to the set of metallic pads of the molded package and protruding from the molded package to provide electrical access to the semiconductor die through the set of metallic pads.

Additional embodiments are directed to a method of providing an electronic device. The method includes providing a molded package having a semiconductor die, a set of metallic pads that electrically couples with the semiconductor die, and perimeter terminals disposed around the set of metallic pads. The method further includes placing a set of connectors in contact with the set of metallic pads. The method further includes, while the set of connectors is in contact with the set of metallic pads and protrudes from the molded package, attaching the set of connectors to the set of metallic pads.

Yet other embodiments are directed to a QFN package (or similar type of package) which includes a semiconductor die, multiple metallic pads disposed within a central region of a bottom surface of the QFN package, and perimeter terminals disposed around outer edges of the bottom surface of the QFN package. The multiple metallic pads electrically couple with the semiconductor die through at least some of the perimeter terminals.

Further embodiments are directed to an electronic device having a molded package which includes a semiconductor die, a set of metallic pads that electrically couples with the semiconductor die, perimeter terminals disposed around the set of metallic pads, and a molded body portion which encapsulates the semiconductor die and defines a bottom surface which exposes the set of metallic pads. The electronic device further has a set of connectors attached to the set of metallic pads of the molded package and extending beyond the bottom surface defined by the molded body portion of molded package to provide electrical access to the semiconductor die through the set of metallic pads. The set of metallic pads of the molded package includes a first metallic pad and a second metallic pad. The set of connectors includes a first dual gauge connector having a pad end which attaches directly to the first metallic pad and a free end, and a second dual gauge connector having a pad end which attaches directly to the second metallic pad and a free end. The free ends of the first and second dual gauge connectors are thicker than the pad ends of the first and second dual gauge connectors. The pad ends of the first and second dual gauge connectors are separated by a first distance. The free ends of the first and second dual gauge connectors are separated by a second distance that is greater than the first distance.

According to one or more further embodiments, the molded package further includes a molded body portion which encapsulates the semiconductor die and defines a bottom surface which exposes the set of metallic pads to the set of connectors.

According to one or more further embodiments, the set of metallic pads includes a first metallic pad and a second metallic pad. Additionally, the set of connectors includes a first connector fused to the first metallic pad and a second connector fused to the second metallic pad. Furthermore, at least a portion of the first connector and at least a portion of the second connector extend beyond the bottom surface defined by the molded body portion.

According to one or more further embodiments, the first connector is laser welded to the first metallic pad and the second connector is laser welded to the second metallic pad.

According to one or more further embodiments, the first connector is soldered to the first metallic pad and the second connector is soldered to the second metallic pad.

According to one or more further embodiments, the perimeter terminals define contact surfaces which are less than 1.0mm wide.

According to one or more further embodiments, the molded package is a quad flat no-leads (QFN) package. Additionally, the bottom surface has a length within a range of 4.0mm to 6.0mm and a width within a range of 4.0mm to 6.0mm.

According to one or more further embodiments, the perimeter terminals are disposed along edges of the bottom surface to enable electrical testing of the electronic device from the bottom surface.

According to one or more further embodiments, a set of perimeter terminals, which is disposed along an edge of the bottom surface, is electrically isolated from the semiconductor die through the molded package.

According to one or more further embodiments, at least one of the set of perimeter terminals is in electrical and physical contact with the set of connectors.

According to one or more further embodiments, the set of metallic pads of the molded package includes a first metallic pad and a second metallic pad. Additionally, the set of connectors includes a first dual gauge connector having a pad end which attaches to the first metallic pad and a free end, and a second dual gauge connector having a pad end which attaches to the second metallic pad and a free end. Furthermore, the free ends of the first and second dual gauge connectors are thicker than the pad ends of the first and second dual gauge connectors.

According to one or more further embodiments, the first dual gauge connector further has an intermediate section which is disposed parallel to an edge of the molded package and between the pad end and the free end of the first dual gauge connector. Additionally, the second dual gauge connector further has an intermediate section which is disposed parallel to the edge of the molded package and between the pad end and the free end of the second dual gauge connector. Furthermore, the intermediate sections of the first and second dual gauge connectors are thinner than the free ends of the first and second dual gauge connectors and create steps between the intermediate sections and the free ends.

According to one or more further embodiments, the pad ends of the first and second dual gauge connectors are separated by a first distance. Additionally, the free ends of the first and second dual gauge connectors are separated by a second distance that is greater than the first distance.

According to one or more further embodiments, the set of metallic pads extend along a bottom surface of the molded package within a plane. Additionally, the first dual gauge connector further has a tab disposed between the pad end and the free end of the first dual gauge connector, and the second dual gauge connector further has a tab disposed between the pad end and the free end of the second dual gauge connector. Furthermore, the tabs of the first and second dual gauge connectors extend perpendicularly from the plane.

According to one or more further embodiments, the molded package includes a sensor. Additionally, the method further includes, prior to attaching the set of connectors to the set of metallic pads of the molded package, electrically accessing the semiconductor die of the molded package through the set of perimeter terminals to perform an electrical test on the sensor to produce a pretested molded package.

The following examples pertain to further embodiments, from which numerous permutations and configurations will be apparent.

Example 1 includes an electronic device which includes a molded package having a semiconductor die, a set of metallic pads that electrically couples with the semiconductor die, and perimeter terminals disposed around the set of metallic pads. The electronic device further includes a set of connectors attached to the set of metallic pads of the molded package and protruding from the molded package to provide electrical access to the semiconductor die through the set of metallic pads.

Example 2 includes the subject matter of Example 1, wherein the molded package further includes a molded body portion which encapsulates the semiconductor die and defines a bottom surface which exposes the set of metallic pads to the set of connectors.

Example 3 includes the subject matter of Example 2 wherein the set of metallic pads includes a first metallic pad and a second metallic pad. Additionally, the set of connectors includes a first connector fused to the first metallic pad and a second connector fused to the second metallic pad. Furthermore, at least a portion of the first connector and at least a portion of the second connector extend beyond the bottom surface defined by the molded body portion.

Example 4 includes the subject matter of Example 3 wherein the first connector is laser welded to the first metallic pad and the second connector is laser welded to the second metallic pad.

Example 5 includes the subject matter of Example 3 wherein the first connector is soldered to the first metallic pad and the second connector is soldered to the second metallic pad.

Example 6 includes the subject matter of any of Examples 2 through 5 wherein the perimeter terminals define contact surfaces which are less than 1.0mm wide.

Example 7 includes the subject matter of any of Examples 2 through 6 wherein the molded package is a quad flat no-leads (QFN) package. Additionally, the bottom surface has a length within a range of 4.0mm to 6.0mm and a width within a range of 4.0mm to 6.0mm.

Example 8 includes the subject matter of any of Examples 2 through 7 wherein the perimeter terminals are disposed along edges of the bottom surface to enable electrical testing of the electronic device from the bottom surface.

Example 9 includes the subject matter of any of Examples 2 through 8 wherein a set of perimeter terminals, which is disposed along an edge of the bottom surface, is electrically isolated from the semiconductor die through the molded package.

Example 10 includes the subject matter of any of Examples 1 through 9 wherein at least one of the set of perimeter terminals is in and physical contact with the set of connectors.

Example 11 includes the subject matter of Example 1 wherein the set of metallic pads of the molded package includes a first metallic pad and a second metallic pad. Additionally, the set of connectors includes a first dual gauge connector having a pad end which attaches to the first metallic pad and a free end, and a second dual gauge connector having a pad end which attaches to the second metallic pad and a free end. Furthermore, the free ends of the first and second dual gauge connectors are thicker than the pad ends of the first and second dual gauge connectors.

Example 12 includes the subject matter of Example 11 wherein the first dual gauge connector further has an intermediate section which is disposed parallel to an edge of the molded package and between the pad end and the free end of the first dual gauge connector. Additionally, the second dual gauge connector further has an intermediate section which is disposed parallel to the edge of the molded package and between the pad end and the free end of the second dual gauge connector. Furthermore, the intermediate sections of the first and second dual gauge connectors are thinner than the free ends of the first and second dual gauge connectors and create steps between the intermediate sections and the free ends.

Example 13 includes the subject matter of Example 12 wherein the pad ends of the first and second dual gauge connectors are separated by a first distance, and wherein the free ends of the first and second dual gauge connectors are separated by a second distance that is greater than the first distance.

Example 14 includes the subject matter of any of Example 11 through Example 13 wherein the set of metallic pads extend along a bottom surface of the molded package within a plane. Additionally, the first dual gauge connector further has a tab disposed between the pad end and the free end of the first dual gauge connector, and the second dual gauge connector further has a tab disposed between the pad end and the free end of the second dual gauge connector. Furthermore, the tabs of the first and second dual gauge connectors extend perpendicularly from the plane.

Example 15 includes a method of providing an electronic device. The method includes providing a molded package having a semiconductor die, a set of metallic pads that electrically couples with the semiconductor die, and perimeter terminals disposed around the set of metallic pads. Additionally, the method includes placing a set of connectors in contact with the set of metallic pads, and while the set of connectors is in contact with the set of metallic pads and protrudes from the molded package, attaching the set of connectors to the set of metallic pads.

Example 16 includes the subject matter of Example 15 wherein the set of metallic pads includes a first metallic pad and a second metallic pad exposed on a bottom surface of the molded package. Additionally, the set of connectors includes a first connector and a second connector. Furthermore, attaching the set of connectors to the set of metallic pads includes fusing the first connector to the first metallic pad and the second connector to the second metallic pad with at least a portion of the first connector and at least a portion of the second connector extending beyond the bottom surface of the molded package.

Example 17 includes the subject matter of Example 16 wherein fusing the first connector to the first metallic pad and the second connector to the second metallic pad includes laser welding the first connector to the first metallic pad and the second connector to the second metallic pad.

Example 18 includes the subject matter of Example 16 wherein fusing the first connector to the first metallic pad and the second connector to the second metallic pad includes soldering the first connector to the first metallic pad and the second connector to the second metallic pad.

Example 19 includes the subject matter of any of Example 15 through Example 18 wherein the molded package includes a sensor. Additionally, the method further includes, prior to attaching the set of connectors to the set of metallic pads of the molded package, electrically accessing the semiconductor die of the molded package through the set of perimeter terminals to perform an electrical test on the sensor to produce a pretested molded package.

Example 20 includes an electronic device having a molded package which includes a semiconductor die, a set of metallic pads that electrically couples with the semiconductor die, perimeter terminals disposed around the set of metallic pads, and a molded body portion which encapsulates the semiconductor die and defines a bottom surface which exposes the set of metallic pads. The electronic device further has a set of connectors attached to the set of metallic pads of the molded package and extending beyond the bottom surface defined by the molded body portion of molded package to provide electrical access to the semiconductor die through the set of metallic pads. The set of metallic pads of the molded package includes a first metallic pad and a second metallic pad. The set of connectors includes a first dual gauge connector having a pad end which attaches directly to the first metallic pad and a free end, and a second dual gauge connector having a pad end which attaches directly to the second metallic pad and a free end. The free ends of the first and second dual gauge connectors are thicker than the pad ends of the first and second dual gauge connectors. The pad ends of the first and second dual gauge connectors are separated by a first distance. The free ends of the first and second dual gauge connectors are separated by a second distance that is greater than the first distance.

As used throughout this document, the words *"comprising," "including," "containing,"* and *"having"* are intended to set forth certain items, steps, elements, or aspects of something in an open-ended fashion. Also, as used herein and unless a specific statement is made to the contrary, the word *"set"* means one or more of something. This is the case regardless of whether the phrase *"set of"* is followed by a singular or plural object and regardless of whether it is conjugated with a singular or plural verb. Also, a *"set of"* elements can describe fewer than all elements present. Thus, there may be additional elements of the same kind that are not part of the set. Further, ordinal expressions, such as *"first," "second," "third,"* and so on, may be used as adjectives herein for identification purposes. Unless specifically indicated, these ordinal expressions are not intended to imply any ordering or sequence. Thus, for example, a *"second"* event may take place before or after *a "first* event," or even if no first event ever occurs. In addition, an identification herein of a particular element, feature, or act as being a *"first"* such element, feature, or act should not be construed as requiring that there must also be a *"second"* or other such element, feature or act. Rather, the *"first"* item may be the only one. Also, and unless specifically stated to the contrary, *"based on"* is intended to be nonexclusive. Thus, *"based on"* should be interpreted as meaning *"based at least in part on"* unless specifically indicated otherwise. Further, although the term *"user"* as used herein may refer to a human being, the term is also intended to cover non-human entities, such as robots, bots, and other computer-implemented programs and technologies. Although certain embodiments are disclosed herein, it is understood that these are provided by way of example only and should not be construed as limiting.

Also, the foregoing description refers to elements or nodes or features being *"connected"* or *"coupled"* together. As used herein, unless expressly stated otherwise, *"connected"* means that one element is directly joined to (or directly communicates with) another element, and not necessarily mechanically. Likewise, unless expressly stated otherwise, *"coupled"* means that one element is directly or indirectly j oined to (or directly or indirectly communicates with, electrically or otherwise) another element, and not necessarily mechanically. Thus, although the schematics and component features shown in the figures depict one exemplary arrangement of elements, additional intervening elements, devices, features, or components may be present in one or more other embodiments of the depicted subject matter.

Those skilled in the art will therefore understand that various changes in form and detail may be made to the embodiments disclosed herein without departing from the scope of the following claims.

## Claims

1. An electronic device (500), comprising:
a molded package (100) including:
a semiconductor die (114),
a set of metallic pads (110) that electrically couples with the semiconductor die (114), and
perimeter terminals (112) disposed around the set of metallic pads (110); and
a set of connectors (510) attached to the set of metallic pads (110) of the molded package (100) and protruding from the molded package (100) to provide electrical access to the semiconductor die (114) through the set of metallic pads (110).

2. The electronic device (500) of claim 1 wherein the molded package (100) further includes:
a molded body (118) portion which encapsulates the semiconductor die (114) and defines a bottom surface (130) which exposes the set of metallic pads (110) to the set of connectors (510).

3. The electronic device (500) of claim 2, wherein the set of metallic pads (110)
includes a first metallic pad (110) and a second metallic pad (110);
wherein the set of connectors (510) includes a first connector (510) fused to the first metallic pad (110) and a second connector (510) fused to the second metallic pad (110); and
wherein at least a portion of the first connector (510) and at least a portion of the second connector (510) extend beyond the bottom surface (130) defined by the molded body portion (118).

4. The electronic device (500) of claim 3, wherein the first connector (510) is laser welded to the first metallic pad (110) and the second connector (510) is laser welded to the second metallic pad (110).

5. The electronic device (500) of claim 3, wherein the first connector (510) is soldered to the first metallic pad (110) and the second connector (510) is soldered to the second metallic pad (110).

6. The electronic device (500) of any of claims 2 to 5, wherein the perimeter terminals (112) define contact surfaces which are less than 1.0mm wide.

7. The electronic device (500) of any of claim 2 to 6, wherein the molded package
(100) is a quad flat no-leads (QFN) package; and
wherein the bottom surface (130) has a length within a range of 4.0mm to 6.0mm and a width within a range of 4.0mm to 6.0mm.

8. The electronic device (500) of any of claims 2 to 7, wherein the perimeter terminals are disposed along edges of the bottom surface to enable electrical testing of the electronic device from the bottom surface.

9. The electronic device (500) of claim 8, wherein a set of perimeter terminals (112), which is disposed along an edge (132) of the bottom surface (130), is electrically isolated from the semiconductor die (114) through the molded package (100).

10. The electronic device (500) of claim 9, wherein at least one of the set of perimeter terminals (112) is in electrical and physical contact with the set of connectors (510).

11. The electronic device (500) of any of the preceding claims, wherein the set of
metallic pads (110) of the molded package (100) includes a first metallic pad (110) and a second metallic pad (110);
wherein the set of connectors (510) includes:
a first dual gauge connector (510(1)) having a pad end (520(1)) which attaches to the first metallic pad (110) and a free end (522(1)), and
a second dual gauge connector (510(2)) having a pad end (520(2)) which attaches to the second metallic pad (110) and a free end (522(2)); and
wherein the free ends (522) of the first and second dual gauge connectors (510) are thicker than the pad ends (520) of the first and second dual gauge connectors (510).

12. The electronic device (500) of claim 11, wherein the first dual gauge connector (510(1)) further has an intermediate section (524(1)) which is disposed parallel to an edge (132) of the molded package (100) and between the pad end (520(1)) and the free end (522(1)) of the first dual gauge connector (510(1));
wherein the second dual gauge connector (510(2)) further has an intermediate (524(2)) section which is disposed parallel to the edge (132) of the molded package (100) and between the pad end (520(2)) and the free end (522(2)) of the second dual gauge connector (510(2)); and
wherein the intermediate sections (524) of the first and second dual gauge connectors (510) are thinner than the free ends (522) of the first and second dual gauge connectors (510) and create steps between the intermediate sections (524) and the free ends (522).

13. The electronic device (500) of claim 11 or 12, wherein the pad ends (520) of the first and second dual gauge connectors (510) are separated by a first distance (D1); and
wherein the free ends (522) of the first and second dual gauge connectors (510) are separated by a second distance (D2) that is greater than the first distance (D1).

14. The electronic device (500) of any of claim 11 to 13, wherein the set of metallic pads (110) extend along a bottom surface (130) of the molded package (100) within a plane;
wherein the first dual gauge connector (510(1)) further has a tab (530) disposed between the pad end (520(1)) and the free end (522(1)) of the first dual gauge connector (510(1));
wherein the second dual gauge connector (510(2)) further has a tab (530) disposed between the pad end (520(2)) and the free end (522(2)) of the second dual gauge connector (510(2)); and
wherein the tabs (530) of the first and second dual gauge connectors (510) extend perpendicularly from the plane.

15. A method of providing an electronic device (500), the method comprising:
providing a molded package (100) having:
a semiconductor die (114),
a set of metallic pads (110) that electrically couples with the semiconductor die (114), and
perimeter terminals (112) disposed around the set of metallic pads (110);
placing a set of connectors (510) in contact with the set of metallic pads (110); and
while the set of connectors (510) is in contact with the set of metallic pads (110) and protrudes from the molded package (100), attaching the set of connectors (510) to the set of metallic pads (110).
